(19)

Europäisches Patentamt

European Patent Office

Office européen des brevets

(11) **EP 2 811 523 A2**

(12) **EUROPEAN PATENT APPLICATION**

(43) Date of publication:
10.12.2014 Bulletin 2014/50

(51) Int Cl.:
*H01L 27/32* (2006.01)  *G06F 3/00* (2006.01)

(21) Application number: 13199551.6

(22) Date of filing: 24.12.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 06.06.2013  CN 201310224411

(71) Applicant: FocalTech Systems, Ltd.
Grand Cayman (KY)

(72) Inventors:
• Mo, Lianghua
518057 Shenzhen (CN)
• Ouyang, Guang
518057 Shenzhen (CN)

(74) Representative: Wilson, Gary
HGF Limited
Delta House
50 West Nile Street
Glasgow G1 2NP (GB)

(54) **Organic light-emitting diode display device integrated with touch control function**

(57)    An organic light-emitting diode display device integrated with a touch control function, includes: a substrate (11); an organic light emitting layer (12) disposed on the substrate; protective glass (13) disposed on the organic light emitting layer; a plurality of sensing electrodes (14) disposed on the protective glass, the plurality of sensing electrodes (14) being arranged in a two-dimensional array; and a touch control chip (10) bound onto the protective glass (13), wherein the touch control chip and the plurality of sensing electrodes are located on a same side of the protective glass, and the touch control chip is connected with each of the plurality of sensing electrodes via a wire. Therefore, the error caused by noises accumulation between the electrodes is avoided, and signal-to-noise ratio is significantly improved.

**Fig. 1**

**Description**

**CROSS REFERENCE TO RELATED APPLICATION**

This application claims the benefit of priority to Chinese Patent Application No.201310224411.4, entitled "ORGANIC LIGHT-EMITTING DIODE DISPLAY DEVICE INTEGRATED WITH TOUCH CONTROL FUNCTION", filed on June 6, 2013 with State Intellectual Property Office of PRC.

**FIELD OF THE DISCLOSURE**

The present application relates to touch control technology, and particularly to an organic light-emitting diode display device integrated with a touch control function.

**BACKGROUND OF THE TECHNOLOGY**

At present, in the organic light-emitting diode (OLED) display device integrated with a touch control function, which is also referred to as organic electroluminescence (OEL) display device, organic semiconductor material and luminescent material are used for light emitting under the driving of the current and hence the function of display is achieved. For the OLED display device integrated with a touch control function, the function of touch detection is achieved by integrating driving/sensing electrodes to the OLED display device. Such an OLED display device integrated with a touch control function is widely applied to various electronic products, and has already prevailed in our work and life. However, the existing OLED display device integrated with a touch control function commonly has problems of poor anti-interference performance, low scanning frame rate, large size, complicated manufacturing processes and so on.

**SUMMARY**

Accordingly, an organic light-emitting diode display device integrated with a touch control function is provided according to an embodiment of the disclosure, to solve at least one of the above problems. The organic light-emitting diode display device integrated with a touch control function includes:

a substrate;

an organic light emitting layer disposed on the substrate;

protective glass disposed on the organic light emitting layer;

a plurality of sensing electrodes disposed on the protective glass, the plurality of sensing electrodes being arranged in a two-dimensional array; and

a touch control chip bound onto the protective glass, wherein the touch control chip and the plurality of sensing electrodes are located on a same side of the protective glass, and the touch control chip is connected with each of the plurality of sensing electrodes via a wire.

Preferably, the sensing electrodes may be made of indium tin oxide (ITO) or graphene.

Preferably, the touch control chip is bound onto the protective glass in a chip-on-glass (COG) mode.

Preferably, the touch control chip includes:

a driving/receiving unit, configured to provide a driving signal to the sensing electrodes and receive a detection signal from the sensing electrodes; and

a detection signal processing unit, configured to determine a touch position according to the detection signal.

Preferably, the detection signal processing unit is configured to obtain a two-dimensional sensing array according to the detection signal, and to determine the touch position according to the two-dimensional sensing array.

Preferably, the detection signal processing unit is configured to determine self-capacitance of each sensing electrode according to the detection signal.

Preferably, the driving/receiving unit is configured to drive the sensing electrodes with a voltage source or a current source, and to detect a voltage, a frequency or an electricity quantity on the sensing electrodes.

Preferably, the driving/receiving unit detects the self-capacitance of each sensing electrode by: driving and detecting the sensing electrode, and driving the rest of the sensing electrodes simultaneously; or driving and detecting the sensing electrode, and driving sensing electrodes periphery to the sensing electrode simultaneously, wherein an signal for driving the sensing electrode and signals for driving the rest of the sensing electrodes and for driving the sensing electrodes periphery to the sensing electrode simultaneously are same voltage or current signals or different voltage or current signals.

Preferably, the driving/receiving unit detects the self-capacitance of each sensing electrode by: detecting all of the sensing electrodes simultaneously; or detecting the sensing electrodes group by group.

Preferably, the driving/receiving unit provides driving signals to the plurality of sensing electrodes simultaneously and receives detection signals.

Preferably, the plurality of sensing electrodes are arranged into groups, the driving/receiving unit sequentially provides a driving signal to each group of sensing electrodes and receives a detection signal.

Preferably, the touch control chip is further configured to adjust sensitivity or a dynamic range of touch detection through parameters of the voltage source or the current source, and the parameters comprise one of amplitude, frequency, time sequence or any combination thereof.

Preferably, any of the sensing electrodes may be in a shape of a rectangle, a diamond, a circle or an oval.

According to embodiments of the present invention, an OLED display device integrated with a touch control function is provided, which adopts sensing electrodes arranged in a two-dimensional array on a surface of the protective glass. Under the premise of achieving multi-touch, errors caused by noises accumulation between the electrodes in the prior art are avoided, and the signal-to-noise ratio is significantly improved. With the solutions of the embodiments of the present invention, power supply noises in the touch screen is greatly eliminated, and interferences from radio frequency (RF) and from other noise sources such as an OLED display module can also be reduced.

Moreover, the touch control chip is connected with each sensing electrode via a wire and the touch control chip is bound onto the protective glass in a COG mode, therefore, difficulties in packaging that may be caused by a large number of pins can be avoided, and the overall size can also be reduced. Moreover, by detecting the sensing electrodes simultaneously or in groups, the scanning time may be reduced significantly, thus avoiding possible problems caused by a large number of sensing electrodes.

**BRIEF DESCRIPTION OF THE DRAWINGS**

The above and other objectives, features and advantages of the embodiments of the present invention will be easier to be understood by referring to the following description for the embodiments of the invention in conjunction with the drawings. Components in the drawings are just for illustrating the principle of the present disclosure. In the drawings, the same or similar technical features or components are indicated by the same or similar reference numerals.

Figure 1 is a schematic diagram of an organic light-emitting diode display device integrated with a touch control function according to an embodiment of the present invention;

Figure 2 is a plan view of a sensing electrode array according to an embodiment of the present invention;

Figure 3 and Figures 4A-4C are schematic diagrams showing sensing electrode driving methods applied to the organic light-emitting diode display device integrated with a touch control function according to the embodiment of the present invention;

Figure 5 and Figure 6 are schematic diagrams showing capacitance detection methods applied to the organic light-emitting diode display device integrated with a touch control function according to the embodiment of the present invention;

Figure 7 shows application situations of the organic light-emitting diode display device integrated with a touch control function according to the embodiment of the present invention;

Figure 8 shows a diagram of the signal-flow in a touch control chip according to the embodiment of the present invention;

Figure 9A shows an example of calculating coordinates of a touch position by using a centroid algorithm; and

Figure 9B shows an example of calculating coordinates of a touch position by using a centroid algorithm in the presence of noise.

## DETAILED DESCRIPTION

Embodiments of the present invention will be described with reference to the drawings hereinafter. Elements and features described in one drawing or one embodiment of the present invention may be combined with one or more elements and features shown in other drawings or embodiments. It should be noted that, for the purpose of clarity, representation and description for components and processes which are known to those skilled in the art and unrelated to the present disclosure are omitted in the drawings and the description.

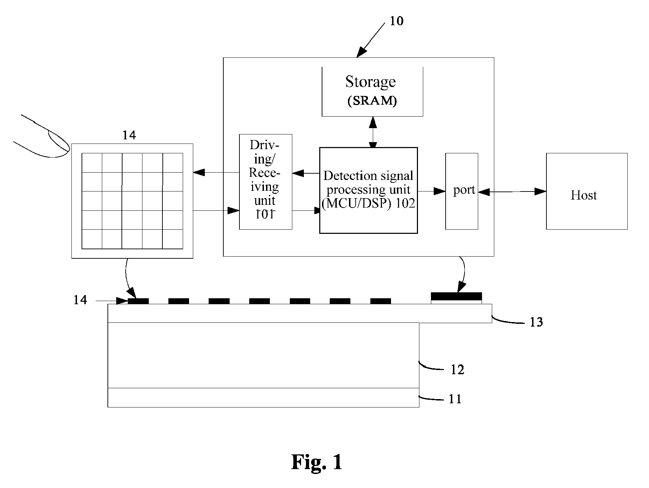

Figure 1 is a schematic diagram of an organic light-emitting diode (OLED) display device according to an embodiment of the present invention. The OLED display device integrated with a touch control function includes: a substrate 11; an organic light emitting layer 12 disposed on the substrate 11; protective glass 13 disposed on the organic light emitting layer 12; a plurality of sensing electrodes 14 disposed on the protective glass 13, where the plurality of sensing electrodes 14 are arranged in a two-dimensional array; and a touch control chip 10 bound onto the protective glass 13, wherein the touch control chip 10 and the plurality of sensing electrodes 14 are located on a same side of the protective glass 13, and the touch control chip 10 is connected with each of the plurality of sensing electrodes 14 via a wire.

The substrate 11 may be made of transparent plastic or glass, to support the whole OLED display device. The organic light emitting layer 12 may include an anode, an organic layer, a conductive layer, an emissive layer and a cathode. The anode is made of transparent N-type oxide semiconductor such as indium tin oxide (ITO). When current flows through, the anode eliminates electrons and increases cavities. The conductive layer is made of organic plastic molecules such as conductive polyaniline polymer, in which the organic plastic molecules transmit cavities coming from the anode. The emissive layer is made of organic plastic molecules that differ from the organic plastic molecules of the conductive layer. For example, polyfluorene may be used as polymer of the emissive layer. These organic plastic molecules transmit electrons coming from the cathode. The cathode may be made of transparent or opaque material. When current flows in the device, the cathode can generate electrons. Protective glass 13 is further disposed on the organic light emitting layer 12.

A plurality of sensing electrodes 14 may be disposed on the upper surface or the lower surface of the protective glass 13, and may be arranged in a two-dimensional array.

For a capacitive touch screen, each electrode is one capacitive sensor for sensing touches on different regions of the touch screen. Each electrode is connected to the touch control chip 10 via a wire. In another aspect, the touch control chip 10 has a large number of pins for being connected to each of the electrodes via wires. Therefore, the touch control chip 10 may preferably be bound onto the protective glass 13 in a chip-on-glass (COG) mode. This bonding may be implemented by, for example, an anisotropic conductive film (ACF). Using the COG mode, the difficulty in conventional packaging due to the large number of chip pins may be resolved.

Moreover, normally physical space is reserved for the touch control chip and the Flexible Printed Circuit (FPC) according to the connection requirement of the FPC, which is disadvantageous for the simplifying of the system. Contrarily, by combining the touch control chip with the touch screen as a whole in COG mode, the distance between the touch control chip and the touch screen is significantly reduced, the overall size is reduced and the overall cost of the assembly is decreased accordingly.; meanwhile, since the electrodes are generally formed by ITO etching performed on the upper surface of the protective glass and the chip is also located on the same upper surface of the protective glass, the wiring between the electrodes and the chip may be implemented in one-step ITO etching, making the manufacturing process greatly simplified.

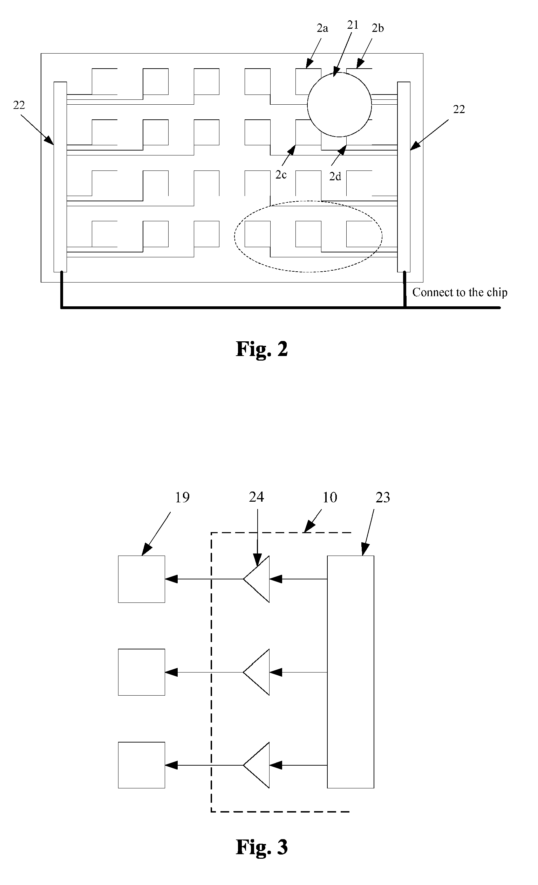

Reference is made to Figure 2 which shows a plan view of a sensing electrode array according to the embodiment of the present invention. It should be understood by those skilled in the art that, in Figure 2, just one arrangement for the sensing electrodes is shown, and in practice the sensing electrodes may be arranged in any two-dimensional array. Moreover, the spacing between any two adjacent sensing electrodes in any direction may be the same, or may also be different. It should also be understood by those skilled in the art that, there may be more sensing electrodes than those shown in Figure 2.

It should be understood that Figure 2 only illustrates one exemplary shape of the sensing electrodes. The sensing electrodes can be rectangular, rhombic, circular, elliptic or even in an irregular shape in other embodiments. The sensing electrodes may be in the same or different shapes. For example, the sensing electrodes in the middle are rhombic while those at the edges are triangular. In addition, the sensing electrodes may be in the same or different dimensions. For example, the sensing electrodes in inner part are bigger while those at the edges are smaller, which is advantageous for the wiring and for the touch accuracy at the edges.

Each sensing electrode is led out via a wire disposed in the gap between the sensing electrodes. Generally, the wires should be as uniform and short as possible. Moreover, the range of the wiring is as narrow as possible under the condition that a safe distance is ensured, thus more space is left for the sensing electrodes and the sensing is more accurate.

The wires, through which each sensing electrode is connected to the bus 22, are connected to the pins on the touch control chip by the bus 22 directly or after proper ordering. There can be numerous sensing electrodes in a large size touch screen. In this situation, a single touch control chip can be configured to control all the sensing electrodes; alternatively multiple touch control chips can be configured to control the sensing electrodes in different regions partitioned on the screen, and the multiple touch control chips can be synchronized with a clock. Here the bus 22 can be divided into several bus groups to connect with different touch control chips, and each touch control chip may control the same or different number of sensing electrodes.

The sensing electrode array shown in Figure 2 is based on the principle of self-capacitance touch detection. Each of the sensing electrodes corresponds to a specific location on the screen. In Figure 2, reference numerals 2a-2d represent different sensing electrodes, and reference numeral 21 represents a touch. The electric charges on a sensing electrode change when the location corresponding to the sensing electrode is touched; hence, it may be determined whether a touch event occurs corresponding to the sensing electrode by detecting the electric charges (current/voltage) on the sensing electrode, which is generally implemented by means of analog-to-digital conversion through an Analog-to-Digital Converter (ADC). The change of the electric charges in the sensing electrode is related to the covered area of the sensing electrode, for example, the change of the electric charges on electrode 2b or 2d is bigger than that on electrode 2a or 2c.

Every location on the screen is provided with a corresponding sensing electrode, and there is no physical connection between the sensing electrodes. With the capacitive touch screen according to the embodiments, a real multi-touch control can be implemented, the problem of ghost point in the self-capacitance touch detection and the error caused by the noise accumulation between the electrodes in the prior art are avoided, and the is highly improved, and the signal to noise ratio is significantly improved.

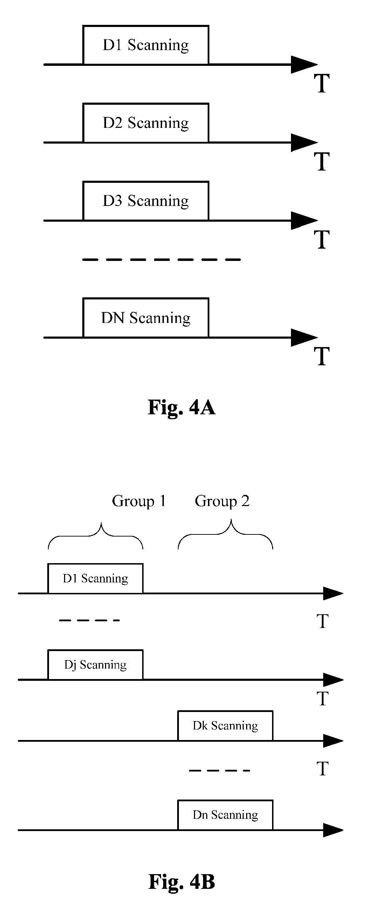

Figure 3 and Figures 4A-4C are schematic diagrams showing sensing electrode driving methods applied to the organic light-emitting diode display device integrated with a touch control function according to the embodiment of the present invention. As shown in Figure 3, a sensing electrode 19 is driven by a driving source 24, which can be a voltage source or a current source. The driving sources 24 for different sensing electrodes 19 may be in different structures. For example, some of the driving sources are voltage sources and some are current sources. In addition, the driving sources 24 for different sensing electrodes 19 may have a same frequency or not. The time sequences of the driving sources 24 are controlled by a time sequence controlling circuit 23.

There are multiple options for driving sequences of the sensing electrodes 19. As shown in Figure 4A, all the sensing electrodes are driven and detected simultaneously. For this method the time to finish a scanning is the shortest, while the number of the driving sources is the most (same as the number of the sensing electrodes). As shown in Figure 4B, the driving sources for the sensing electrodes may be divided into several groups for sequentially driving electrodes in corresponding regions. The driving sources can be reused in this method, while the scanning time is increased. A compromise may be met between the advantage of reusing the driving sources and the scanning time by selecting a proper number of the groups.

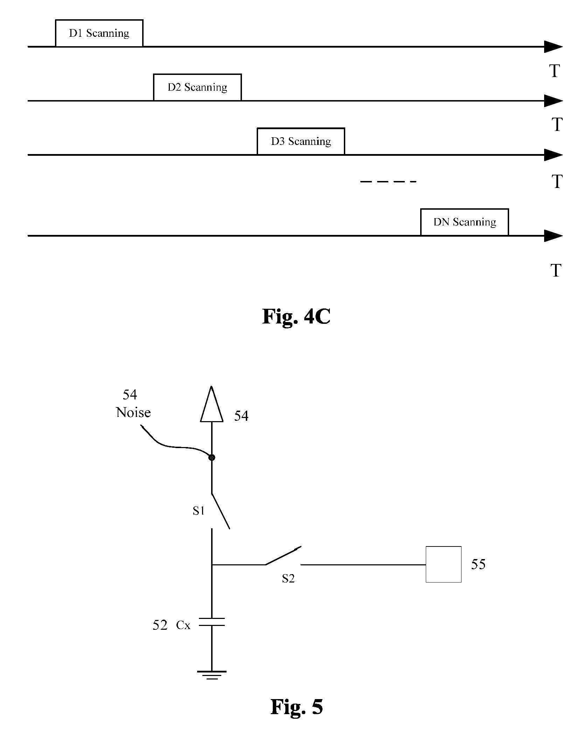

Figure 4C illustrates a conventional scanning method for mutual capacitance touch detection. Supposing that there are N driving channels (TX) and the scanning time of each TX is Ts, then the time for scanning one frame is N*Ts. By contrast, with the sensing electrode driving method according to the embodiments of the invention, the shortest scanning time for one frame is only Ts since all the sensing electrodes are detected simultaneously. That is to say, the scan frame rate can be enhanced by N times with the method according to the disclosure as compared with the conventional mutual capacitance touch detection.

Considering a mutual capacitance touch screen with 40 driving channels and the scanning time of $500\mu s$ for each driving channel, the scanning time for the whole touch screen (one frame) is 20ms, i.e., the frame rate is 50Hz, which is usually inadequate for good usage experience. The problem can be solved by the solution provided in the embodiments. By arranging the sensing electrodes are in a two-dimensional array, all the electrodes may be detected simultaneously, and the frame rate reaches 2000Hz when the detection time for each electrode keeps at $500\mu s$, which is highly above application requirements of most touch screens. Excessive scanning data can be utilized by a digital signal processing unit, for example, anti-interference or touch traces optimization, in order to achieve better effects.

Preferably, the self-capacitance of each sensing electrode is detected. The self-capacitance of the sensing electrode may be the capacitance to the ground of the sensing electrode.

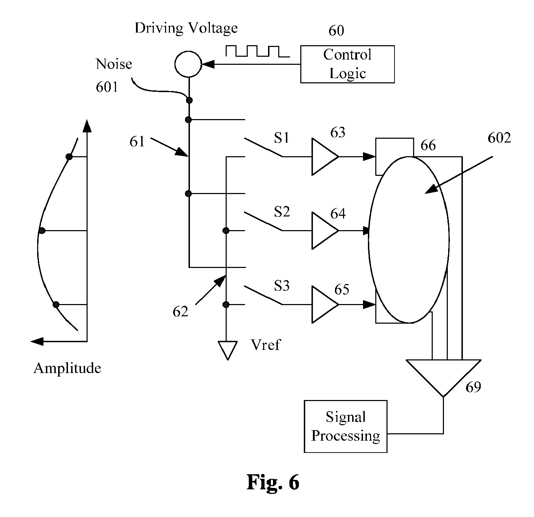

As an example, the charge detection may be used. Figure 5 and Figure 6 are schematic diagrams showing capacitance detection methods applied to the organic light-emitting diode display device integrated with a touch control function according to the embodiment of the present invention. In Figure 5, a constant voltage $V_1$ is provided by a driving source 51. The voltage $V_1$ may be positive, negative or equivalent to the ground. References S1 and S2 represent two controlled switches, reference numerous 52 represents the capacitance to the ground of a sensing electrode, and reference numerous 55 represents an electric charge receiving module which can clamp an input voltage to a specific value V2 and measure an input or output quantity of the electric charges. Firstly, S1 is on and S2 is off, the upper plate of Cx is charged to the voltage V1 provided by the driving source 51; then S1 is off and S2 is on, Cx exchanges electric charges with the electric receiving module 55. Assuming that the amount of charge transfer is Q1 and the voltage on the upper plate of Cx turns into V2, it may be concluded that $Cx=Q1/(V2-V1)$ from $C=Q/\Delta V$; hence the self-capacitance is detected.

Alternatively, a current source may be used, or the self-capacitance can be detected based on the frequency of the sensing electrode.

Optionally, in the case that multiple driving sources are adopted, when a sensing electrode is detected, a voltage different from that of the driving source adopted for the sensing electrode being detected can be chosen for the sensing electrodes adjacent or peripheral to the sensing electrode being detected. For convenient illustration, Figure 6 shows only three sensing electrodes: an electrode 67 being detected, and two adjacent electrodes 66 and 68. It should be understood by those skilled in the art that the following example is also applicable for situations with more sensing electrodes.

A driving source 64, which is connected to the electrode 67 being detected, is connected to a voltage source 61 through a switch S2 to drive the electrode 67 being detected. The electrodes 66 and 68 adjacent to the electrode 67 being detected are connected to driving sources 63 and 65 respectively, and can be connected to the voltage source 61 or a specific reference voltage 62 (e.g., the ground) through switches S1 and S3 respectively. The electrode being detected and the peripheral electrodes are driven simultaneously by the same voltage source when the switches S1 and S3 are connected to the voltage source 61. In this case, the differences between the electrode being detected and the peripheral electrodes are reduced, which is advantageous for reducing the capacitance of the electrode being detected and preventing a false touch caused by a water drop.

Preferably, the touch control chip is configured to adjust the sensitivity or the dynamic range of touch detection by means of parameters of the driving source. The parameters include any one of the amplitude, the frequency, the time sequence or the combination thereof. As shown in Figure 6, for example, the parameters of each driving source (e.g., the driving voltage, current and frequency) and the time sequence of the driving sources can be controlled by the control logic 60 of a signal driving circuit in the touch control chip. Different circuit operating modes, e.g., high sensitivity, medium sensitivity or low sensitivity, or different dynamic ranges can be adjusted through the parameters.

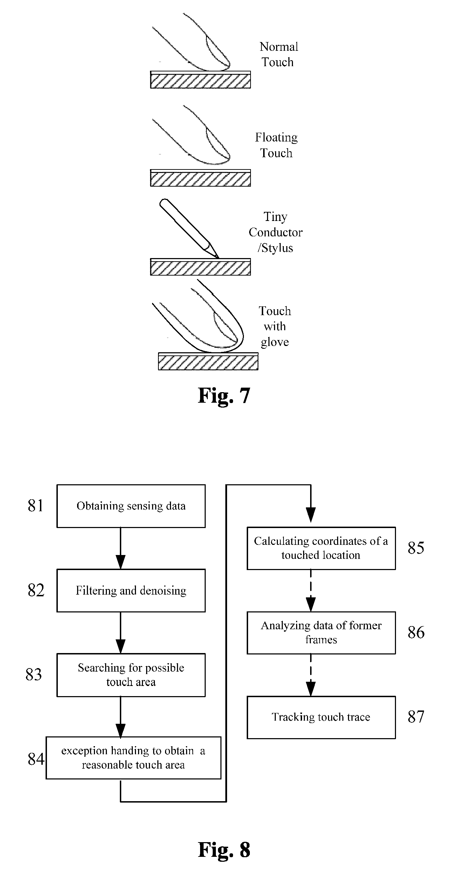

The different circuit operating modes can be configured to different application situations. Figure 7 shows four application situations of the organic light-emitting diode display device integrated with a touch control function according to the embodiment of the present invention: a normal finger touch, a floating finger touch, a touch with an active/passive stylus or a tiny conductor and a touch with a finger in a glove. One or more normal touches and one or more touches with the tiny conductor can be detected in conjunction with the parameters described above. It should be understood by those skilled in the art that although it is shown in Figure 6 that the signal receiving unit 69 is separated from the signal driving circuit 60, they can be implemented in one circuit in other embodiments.

Figure 8 illustrates a signal flow in a touch control chip according to an embodiment of the invention. A change occurs to the capacitance of a sensing electrode when the sensing electrode is touched, and the change is converted into a digital quantity through an ADC to recover the information of the touch. The change of the capacitance generally is related to a covered area of the sensing electrode by a touch object. The sensing data of the sensing electrode is received by the signal receiving unit 69 and the information of the touch is recovered therefore through a signal processing unit.

As an example, a data processing method for the signal processing unit will be described in detail with reference to Figure 8 hereinafter. Figure 8 shows a signal-flow of the touch control chip according to the embodiment of the present invention. The data processing method as shown in Figure 8 includes the following steps.

Step 81, obtaining sensing data.

Step 82, filtering and denoising the sensing data. This step is to remove as many noises as possible from an original image for the convenience of subsequent calculation. Spatial-domain filtering, time-domain filtering or threshold filtering may be used for this step.

Step 83, searching for possible touch areas. The areas include real touch areas and invalid signals. The invalid signals include large-area touch signals, power supply noise signals, suspending abnormal signals, water drop signals, etc. In the invalid signals, some can be similar to the real touches, some may interfere with the real touches, or some may be interpreted as the real touches.

Step 84, exception handing, which is to remove the invalid signals and obtain a reasonable touch area.

Step 85, calculating coordinates of a touch position based on the data of the reasonable touch area.

Preferably, the coordinates of the touch position can be determined based on a two-dimensional sensing array. Specifically, the coordinates of the touch position can be determined based on the two-dimensional sensing array through the centroid algorithm.

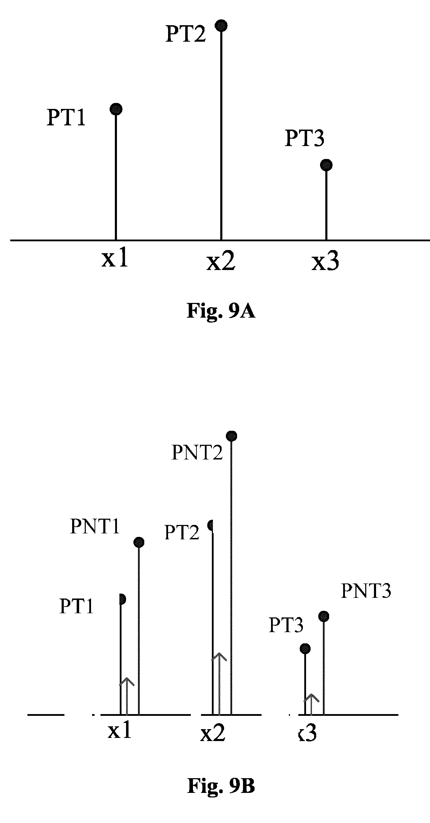

Figure 9A illustrates an example of calculating the coordinates of the touch position through the centroid algorithm. In the following it is only illustrated calculating the coordinate of one dimension of the touch position for brevity. It should be understood by those skilled in the art that, all the coordinates can be obtained with the same or a similar method. Supposing that the sensing electrodes 66 to 68 shown in Figure 6 are covered by finger(s), the corresponding pieces of sensing data are PT1, PT2 and PT3, respectively, and corresponding coordinates of the sensing electrodes 66 to 68 are $x1$, $x2$ and $x3$, respectively, then the coordinate of the touch position obtained through the centroid algorithm is:

$$X_{touch} = \frac{PT1 * x1 + PT2 * x2 + PT3 * x3}{PT1 + PT2 + PT3} \qquad (1)$$

Optionally, step 86 of analyzing the data of former frames to obtain the data of a current frame from the data of multiple frames can be performed after obtaining the coordinate of the touch position.

Optionally, step 87 of tracking touch traces based on the data of the multiple frames can be performed after obtaining the coordinate of the touch position. In addition, event information can be obtained and reported based on the operation of the user.

The OLED display device integrated with a touch control function according to the embodiment of the present invention can solve a problem of noise accumulation in the prior art, under the premise of achieving multi-touch.

Illustrating that a power supply common-mode noise is introduced to a location 601 as shown in Figure 6, effect on the calculation of the touch position by the noise is analyzed as follows.

In a touch system based on the mutual capacitance touch detection in the prior art, there are a plurality of driving channels (TXs) and a plurality of receiving channels (RXs), and each RX is connected to all the TXs. A common-mode interference signal, once introduced into the system, is transmitted through all the RXs because of the connectivity of the RXs. In particular, in the case that a plurality of noise sources are present in one RX, the noises generated by the noise sources will be accumulated, thereby, the amplitude of the resultant noise is increased. The voltage signal on the capacitor being measured fluctuates because of the noise, hence false detection occurs on an untouched point.

In the OLED display device integrated with a touch control function according to the embodiment of the present invention, the sensing electrodes are not physically connected out the touch control chip, hence the noises can not transmit and accumulate among the sensing electrodes and the false detection is avoided.

Taking the approach of detecting the voltage as an example. The voltage on a touched electrode changes because of the noise, and the sensing data of the touched electrode changes consequently. According to the principle of self-capacitance touch detection, the sensing value caused by the noise is proportional to the covered area of the touched electrode, the same as the case of a normal touch.

Figure 9B illustrates calculating the coordinate of a touch position through the centroid algorithm in with the presence of noise. Supposing that the sensing values caused by the normal touches are PT1, PT2 and PT3, and the sensing values caused by the noises are PN1, PN2 and PN3, then (taking the sensing electrodes 66 to 68 as examples):

$$PT1 \propto C68, \quad PT2 \propto C67, \quad PT3 \propto C66$$

$$PN1 \propto C68, \quad PN2 \propto C67, \quad PN3 \propto C66$$

here: PN1 = K*PT1, PN2 = K*PT2, PN3 = K*PT3, K is a constant.

In the case that the polarities of the voltages of the noise and the driving source are the same, the final pieces of sensing data because of voltage superposition are:

$$PNT1 = PN1+PT1 = (1+K)*PT1$$

$$PNT2 = PN2+PT2 = (1+K)*PT2$$

$$PNT3 = PN3+PT3 = (1+K)*PT3$$

Then, the coordinate obtained by using the centroid algorithm is :

$$X_{touch} = \frac{PNT1 * x1 + PNT2 * x2 + PNT3 * x3}{PNT1 + PNT2 + PNT3}$$

$$= \frac{(1 + K) * PT1 * x1 + (1 + K) * PT2 * x2 + (1 + K) * PT3 * x3}{(PT1 + PT2 + PT3) * (1 + K)}$$

$$= \frac{PT1 * x1 + PT2 * x2 + PT3 * x3}{(PT1 + PT2 + PT3)} \qquad (2)$$

Apparently Formula (2) is the same as Formula (1). Therefore, the capacitive touch screen according to the embodiments of the invention is immune to the common-mode noise. The finally determined coordinate may not be affected if only the noise does not go beyond the dynamic range of the system.

A valid signal may be reduced in the case that the polarities of the voltages of the noise and the driving source are opposite. It can be seen from the above analysis that, the finally determined coordinate is not affected if the reduced valid signal is detectable. The data of the current frame becomes invalid if the reduced valid signal is not detectable. Nevertheless, the data of the current frame can be recovered through the data of multiple frames because the scanning frequency of the capacitive touch screen according to the embodiments of the invention may be up to N (N is usually bigger than 10) times of a normal scanning frequency. It should be understood by those skilled in the art that, a normal report rate may not be affected by the processing with the data of the multiple frames because the scanning frequency is much higher than a practically required report rate.

Similarly, in the case that the noise goes beyond the dynamic range of the system in a limited amount, the current frame can also be recovered through the date of the multiple frames to obtain the right coordinate. This method of inter-frame processing is also applicable for RF immunity and interference from other noise sources such as a liquid crystal display module.

It should be noted that, used herein, the wording "comprise/include" indicates the presence of the stated features, elements, steps, operations, or components, but do not exclude the presence or addition of one or more other features, elements, steps, operations, or components.

The embodiments and the advantages of the disclosure are described above. However, it should be understood that various variations, alternations and modifications may be made to the present disclosure without departing from the spirit and scope of the present disclosure defined in the claims. Also, the scope of the present disclosure is not limited to the specific embodiments of the processes, devices, means, methods and steps described in the specification. From the disclosure it will be easily understood by those skilled in the art that processes, devices, means, methods or steps currently available and to be developed, which perform the substantially same function as the corresponding embodiments herein or obtain the substantially same result as the corresponding embodiments herein, may be used. Therefore, the claims are intended to include these processes, devices, means, methods or steps.

**Claims**

1. An organic light emitting diode display device integrated with a touch control function, comprising:

    a substrate;
    an organic light emitting layer disposed on the substrate;
    protective glass disposed on the organic light emitting layer;
    a plurality of sensing electrodes disposed on the protective glass, the plurality of sensing electrodes being arranged in a two-dimensional array; and
    a touch control chip bound onto the protective glass, wherein the touch control chip and the plurality of sensing electrodes are located on a same side of the protective glass, and the touch control chip is connected with each of the plurality of sensing electrodes via a wire.

2. The organic light emitting diode display device integrated with a touch control function according to claim 1, wherein the sensing electrodes are made of Indium Tin Oxide or Graphene.

3. The organic light emitting diode display device integrated with a touch control function according to claim 1, wherein the touch control chip is bound onto the protective glass in a chip-on-glass mode.

4. The organic light emitting diode display device integrated with a touch control function according to claim 1, wherein the touch control chip comprises:

    a driving/receiving unit, configured to provide a driving signal to the sensing electrodes and receive a detection signal from the sensing electrodes; and
    a detection signal processing unit, configured to determine a touch position according to the detection signal.

5. The organic light emitting diode display device integrated with a touch control function according to claim 4, wherein the detection signal processing unit is configured to obtain a two-dimensional sensing array according to the detection signal, and to determine the touch position according to the two-dimensional sensing array.

6. The organic light emitting diode display device integrated with a touch control function according to claim 4, wherein the detection signal processing unit is configured to detect a self-capacitance of each sensing electrode according to the detection signal.

7. The organic light emitting diode display device integrated with a touch control function according to claim 6, wherein the driving/receiving unit is configured to drive the sensing electrodes with a voltage source or a current source, and to detect a voltage, a frequency or an electric quantity on the sensing electrodes.

8. The organic light emitting diode display device integrated with a touch control function according to claim 7, wherein the driving/receiving unit detects the self-capacitance of each sensing electrode by:

    driving and detecting the sensing electrode, and driving the rest of the sensing electrodes simultaneously; or
    driving and detecting the sensing electrode, and driving sensing electrodes periphery to the sensing electrode simultaneously,
    wherein an signal for driving the sensing electrode and signals for driving the rest of the sensing electrodes and for driving the sensing electrodes periphery to the sensing electrode simultaneously are same voltage or current signals or different voltage or current signals.

9. The organic light emitting diode display device integrated with a touch control function according to claim 8, wherein the driving/receiving unit detects the self-capacitance of each sensing electrode by:

    detecting all of the sensing electrodes simultaneously; or
    detecting the sensing electrodes group by group.

10. The organic light emitting diode display device integrated with a touch control function according to claim 4, wherein the driving/receiving unit provides driving signals to the plurality of sensing electrodes simultaneously and receives detection signals.

11. The organic light emitting diode display device integrated with a touch control function according to claim 4, wherein the plurality of sensing electrodes are arranged in groups, the driving/receiving unit sequentially provides a driving signal to each group of sensing electrodes and receives a detection signal.

12. The organic light emitting diode display device integrated with a touch control function according to claim 7, wherein the touch control chip is further configured to adjust sensitivity or a dynamic range of touch detection through parameters of the voltage source or the current source, and the parameters comprise one of amplitude, frequency, time sequence or any combination thereof.

13. The organic light emitting diode display device integrated with a touch control function according to claim 1, wherein any of the sensing electrodes is rectangular, rhombic, circular or elliptic.

**Fig. 1**

**Fig. 2**

**Fig. 3**

D1 Scanning

T

D2 Scanning

T

D3 Scanning

T

– – – – – –

DN Scanning

T

**Fig. 4A**

Group 1    Group 2

D1 Scanning

T

– – – –

Dj Scanning

T

Dk Scanning

T

– – – –

Dn Scanning

**Fig. 4B**

D1 Scanning

T

D2 Scanning

T

D3 Scanning

T

DN Scanning

T

**Fig. 4C**

54
Noise

54

S1

55

S2

52 Cx

**Fig. 5**

**Fig. 6**

Normal
Touch

Floating
Touch

Tiny
Conductor
/Stylus

Touch
with
glove

**Fig. 7**

81 Obtaining sensing data

82 Filtering and denoising

83 Searching for possible touch area

84 exception handing to obtain a reasonable touch area

Calculating coordinates of a touched location 85

Analyzing data of former frames 86

Tracking touch trace 87

**Fig. 8**

Fig. 9A

Fig. 9B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201310224411